# EUROPEAN PATENT APPLICATION

(11) **EP 3 261 144 A1**
(43) Date of publication of application: **27.12.2017**
(21) Application number: 15882741.0
(22) Date of filing: 15.12.2015
(51) Int. Cl.: H01L 51/50, C08L 25/04, C09D 11/30

(54) **INK COMPOSITION FOR ORGANIC LIGHT EMITTING DEVICE, AND ORGANIC LIGHT EMITTING ELEMENT**

(30) Priority: 20.02.2015 JP 2015031715
(71) Applicant: DIC Corporation, Tokyo 174-8520 (JP)
(72) Inventor: GOTOU Yuusaku, Sakura-shi Chiba 285-8668 (JP); OTSUKI Eiji, Sakura-shi Chiba 285-8668 (JP); FUKUI Hiroyuki, Sakura-shi Chiba 285-8668 (JP)
(74) Representative: Adam, Holger
(86) International application number: PCT/JP2015/085054
(87) International publication number: WO 2016/132640

(57) **Abstract**

There is provided an ink composition for an organic light-emitting device which can easily form a light-emitting layer having more excellent uniformity and which is suitable for forming a light-emitting layer by a wet method. An ink composition for an organic light-emitting device includes a light-emitting material, a binder resin, and a solvent, the binder resin containing a multi-branched copolymer of a monovinyl compound composed of a styrene-based monomer as an essential component with a multifunctional vinyl compound containing two or more ethylenically unsaturated double bonds, and the copolymer having a weight-average absolute molecular weight within a range of 200,000 to 800,000 determined by gel permeation chromatography using a multi-angle laser light scattering detector and a degree of branching within a range of 0.20 to 0.55 determined from an inertial radius. An organic light-emitting device includes a positive electrode, a light-emitting layer, and a negative electrode, the light-emitting layer containing the binder resin.

## Description

### Technical Field

The present invention relates to an in composition for an organic light-emitting device and an organic light-emitting device.

### Background Art

Organic light-emitting devices are expected as display devices using light-emitting materials which emit light by flowing a current and having the potential of being able to be thinner than a liquid crystal and plasma. A typical example of the organic light-emitting devices is an electroluminescence device.

The organic light-emitting devices generally have a laminated structure, and a known example thereof is a laminate having an essential layer configuration including a positive electrode, a light-emitting layer containing a light-emitting material, and a negative electrode. Also, there is known an organic light-emitting device having a layer configuration including a hole transport layer provided between a positive electrode and a light-emitting layer and an electron transport layer provided between a negative electrode and the light-emitting layer.

The organic light-emitting devices generally have a mechanism in which the holes generated from the positive electrode and the electrons generated from the negative electrode move between layers and combined in the light-emitting layer, thereby emitting light. Therefore, in order to properly emit light, it is necessary to allow the holes and the electrons to stably move through the interface between the light-emitting layer and an adjacent layer. Thus, a high degree of uniformity is required at the interface. The light-emitting layer is composed of a light-emitting material as a main material, but the light-emitting material often has high crystallinity or has alignment and often has low solubility in a solvent. Thus, regardless of whether the light-emitting material is vapor-deposited on the adjacent layer in a dry method or a solution or dispersion containing the light-emitting material is applied on the adjacent layer and dried in a wet method, it is actually difficult to form the light-emitting layer having neither irregularities, pin holes, nor the like and having a high degree of uniformity.

From this viewpoint, examination is in progress to form the light-emitting layer by the wet method which does not require an expensive apparatus used for carrying out by the dry method and which can more easily form the light-emitting layer with high productivity, and the light-emitting layer becomes to be formed by applying a solution or dispersion containing a light-emitting material, a binder resin, and a solvent and then drying the solution or dispersion.

Patent Literature 1 proposes that in an ink for an organic light-emitting device which contains a light-emitting material, a binder resin, and a solvent, for example, a copolymer having a repeating unit derived from styrene and/or olefin, such as 1,4-polyisoprene, polynorbornene, polystyrene, polyethylene, or the like, is used as the binder resin.

However, Patent Literature 1 uses linear polystyrene, a block copolymer of styrene with another comonomer, a graft copolymer of styrene with another comonomer as the binder resin, but does not specify what the polystyrene is used in an example. In addition, the linear polystyrene which is general polystyrene has insufficient affinity for the light-emitting material, and thus the present situation is that a light-emitting layer having neither irregularity, pinholes, nor the like, and having satisfactory excellent uniformity is not yet formed.

### Citation List

### Patent Literature

PTL 1: Japanese Unexamined Patent Application Publication (Translation of PCT Application) No. 2013-516053

### Summary of Invention

### Technical Problem

Accordingly, a problem to be solved by the present invention is to provide an ink composition for an organic light-emitting device which can easily form a light-emitting layer having more excellent uniformity and which is suitable for forming a light-emitting layer by a wet method. Another problem is to provide an organic light-emitting device including a light-emitting layer formed by the wet method and having both more excellent uniformity and excellent light emission properties.

### Solution to Problem

As a result of earnest investigation for solving the problems, the inventors found that the problems can be solved, by not using a styrene-based polymer described in Patent Literature 1 as a binder resin, but by using a binder resin containing a multi-branched copolymer of a monovinyl compound composed of a styrene-based monomer as an essential component with a multifunctional vinyl compound containing two or more ethylenically unsaturated double bonds, the copolymer having a highly branched structure and a high molecular weight, leading to the achievement of the present invention.

That is, the present invention provides an ink composition for an organic light-emitting device, the composition containing a light-emitting material, a binder resin, and a solvent, the binder resin containing a multi-branched copolymer of a monovinyl compound composed of a styrene-based monomer as an essential component with a multifunctional vinyl compound containing two or more ethylenically unsaturated double bonds, and the copolymer having a weight-average absolute molecular weight within a range of 200,000 to 800,000 determined by gel permeation chromatography using a multi-angle laser light scattering detector and a degree of branching within a range of 0.20 to 0.55 determined from an inertial radius.

Also, the present invention provides an organic light-emitting device including a positive electrode, a light-emitting layer, and a negative electrode, the light-emitting layer containing a light-emitting material and a binder resin containing a multi-branched copolymer of a monovinyl compound composed of a styrene-based monomer as an essential component with a multifunctional vinyl compound containing two or more ethylenically unsaturated double bonds, and the copolymer having a weight-average absolute molecular weight within a range of 200,000 to 800,000 determined by gel permeation chromatography using a multi-angle laser light scattering detector and a degree of branching within a range of 0.20 to 0.55 determined from an inertial radius. Advantageous Effects of Invention

According to the present invention, an ink composition for an organic light-emitting device contains, as a binder resin, a binder resin containing a styrene-based multi-branched copolymer having a highly branched structure and a high molecular weight, and thus exhibits an especially remarkable technical effect that a light-emitting layer having more excellent uniformity can be obtained.

Also, an organic light-emitting device according to the present invention contains, as a binder resin, a binder resin containing a styrene-based multi-branched copolymer having a highly branched structure and a high molecular weight, and thus a light-emitting layer having a high degree of uniformity can be formed. Therefore, there is exhibited an especially remarkable technical effect that as compared with an organic light-emitting device having a light-emitting layer containing a general binder resin, an organic light-emitting device having both more excellent uniformity and excellent light emission properties can be obtained. Brief Description of Drawings

[Fig. 1] Fig. 1 is a chromatogram for measuring the molecular weight of a binder resin by GPC-MALLS.
[Fig. 2] Fig. 2 is a log-log graph showing the degree of branching of a binder resin containing the multi-branched copolymer determined from the gradient of a straight line, in which the weight-average absolute molecular weight is plotted on the X-axis, and the inertial radius is plotted on the Y-axis.

### Description of Embodiments

A mode for carrying out the present invention is described in detail below.

### <Ink composition for organic light-emitting device>

An ink composition for an organic light-emitting device according to the present invention contains a light-emitting material, a binder resin containing a specified polymer as described above and containing a styrene-based monomer as an essential component, and a solvent. The ink composition for an organic light-emitting device according to the present invention contains the light-emitting material and is thus, in principle, used for forming a light-emitting layer of an organic light-emitting device.

### [Light-emitting material]

The light-emitting material has the function of contributing directly or indirectly to light emission using holes and electrons in the light-emitting layer. In the specification, "light emission" includes fluorescent light emission and phosphorescent light emission.

In an embodiment, the light-emitting material contains a host material and a dopant material.

### (Host material)

The host material generally has the function of transporting the holes and electrons injected into the light-emitting layer.

The host material is not particularly limited as long as it has the function described above. Host materials are classified into a high-molecular host material and a low-molecular host material. In the specification, the term "low molecular" represents a weight-average molecular weight (Mw) of 5,000 or less. While, in the specification, the term "high molecular" represents a weight-average molecular weight (Mw) exceeding 5,000. In this case, in the specification, a value measured by using gel permeation chromatography (GPC) using polystyrene as a standard material is used as the "weight-average molecular weight (Mw)".

Examples of the high-molecular host material include, but are not particularly limited to, poly(9-vinylcarbazole) (PVK), polyfluorene (PF), polyphenylene vinylene (PPV), a copolymer containing the monomer unit thereof, and the like.

The weight-average molecular weight (Mw) of the high-molecular host material is preferably over 5,000 and 5,000,000 or less and more preferably over 5,000 and 1,000,000 or less.

Examples of the low-molecular host material include, but are not particularly limited to, 4,4'-bis(9H-carbazol-9-yl)biphenyl (CBP), bis(2-methyl-8-quinolinolate)-4-(phenylphenolato)aluminum (BAIq), 1,3-dicarbazolylbenzene (mCP), 4,4'-bis(9-carbazolyl)-2,2'-dimethylbiphenyl (CDBP), N,N'-dicarbazolyl-1,4-dimethylbenzene (DCB), 2,7-bis(diphenylphosphine oxide)-9,9-dimethylfluorene (PO6), 3,5-bis(9-carbazolyl)tetraphenylsilane (SimCP), 1,3-bis(triphenylsilyl)benzene (UGH3), 1,3,5-tris[4-(diphenylamino)phenyl]benzene (TDAPB), 9,9'-(p-tert-butylphenyl)-1,3-biscarbazole, and the like.

The weight-average molecular weight (Mw) of the low-molecular host material is preferably 100 to 5,000 and more preferably 300 to 5,000.

Among the host materials, the low-molecular host material is preferably used as the host material, 4,4'-bis(9H-carbazol-9-yl)biphenyl (CBP), bis(2-methyl-8-quinolinolate)-4-(phenylphenolato)aluminum (BAlq), 9,9'-(p-tert-butylphenyl)-1,3-biscarbazole are more preferably used, and 4,4'-bis(9H-carbazol-9-yl)biphenyl (CBP) and 9,9'-(p-tert-butylphenyl)-1,3-biscarbazole are still more preferably used.

The host materials may be used alone or in combination of two or more.

The content of the host material is preferably 0.1 to 10% by mass and more preferably 0.1 to 5% by mass relative to the total amount of the ink composition for an organic light-emitting device. The host material content of 0.1% by mass or more is preferred because the intermolecular distance between a host molecule and a dopant molecule can be shortened. While the host material content of 10% by mass or less is preferred because a decrease in quantum yield can be suppressed.

### (Dopant material)

The dopant material has the function of emitting light by using the energy produced by recombination between the transported holes and electrons.

The dopant material is not particularly limited as long as it has the function described above. Dopant materials are generally classified into a high-molecular dopant material and a low-molecular dopant material.

Examples of the high-molecular dopant material include, but are not particularly limited to, polyphenylene violene (PPV), cyanopolyphenylene vinylene (CN-PPV), poly(fluorenylene ethynylene) (PFE), polyfluorene (PFO), polythiophene polymer, polypyridine, a copolymer containing monomer unit thereof, and the like.

The weight-average molecular weight (Mw) of the high-molecular dopant material is preferably over 5,000 and 5,000,000 or less and more preferably over 5,000 and 1,000,000 or less.

Examples of the low-molecular dopant material include, but are not particularly limited to, a fluorescent light-emitting material, a phosphorescent light-emitting material, and the like.

Examples of the fluorescent light-emitting material include naphthalene, perylene, pyrene, chrycene, anthracene, coumarine, p-bis(2-phenylethenyl)benzene, quinacridone, coumarine, aluminum complexes and the like such as Al (C₉H₆NO)₃ and the like, rubrene, primidone, dicyanomethylene-2-methyl-6-(p-dimethylaminostyryl)-4H-pyrane (DCM), benzopyrane, rhodamine, benzothioxanthene, azabenzothioxanthene, and derivatives thereof, and the like.

An example of the phosphorescent light-emitting material is a complex containing a center metal of Group 7 to Group 11 in the periodic table and an aromatic ligand coordinated to the center metal.

Examples of the center metal of Group 7 to Group 11 in the periodic table include ruthenium, rhodium, palladium, osmium, iridium, gold, platinum, silver, copper, and the like. Among these, iridium is preferred as the center metal.

Examples of the ligand include phenylpyridine, p-tolylpyridine, thienylpyridine, difluorophenylpyridine, phenylisoquinoline, fluorenopyridine, fluorenoquinoline, acetylacetone, and derivatives thereof, and the like. Among these, phenylpyridine, p-tolylpyridine, and derivatives thereof are preferred as the ligand, and p-tolylpyridine and derivatives thereof are more preferred.

Specific examples of the phosphorescent light-emitting material include tris(2-phenylpyridine) iridium (Ir(ppy)₃), tris(2-phenylpyridine) ruthenium, tris(2-phenylpyridine) palladium, bis(2-phenylpyridine) platinum, tris(2-phenylpyridine) osmium, tris(2-phenylpyridine) rhenium, tris[2-(p-tolyl)pyridine] iridium (Ir(mppy)₃), tris[2-(p-tolyl)pyridine] ruthenium, tris[2-(p-tolyl)pyridine] palladium, tris[2-(p-tolyl)pyridine] platinum, tris[2-(p-tolyl)pyridine] osmium, tris[2-(p-tolyl)pyridine] rhenium, octaethyl platinum porphyrin, octaphenyl platinum porphyrin, octaethyl palladium porphyrin, octaphenyl palladium porphyrin, and the like.

Among the above, the dopant material is preferably the low-molecular dopant material, more preferably the phosphorescent light-emitting material, and still more preferably tris[2-(p-tolyl)pyridine] iridium (Ir(mppy)₃).

The weight-average molecular weight (Mw) of the low-molecular dopant material is preferably 100 to 5,000 and more preferably 100 to 3,000.

The dopant materials may be used alone or in combination of two or more.

The content of the dopant material is preferably 0.01% to 10% by mass and more preferably 0.01% to 5% by mass relative to the total amount of the ink composition for an organic light-emitting device. The dopant material content of 0.01% by mass or more is preferred because emission intensity can be increased. While the dopant material content of 10% by mass or less is preferred because a decrease in quantum yield can be suppressed.

Among the above, from the viewpoint that a higher luminous efficiency can be obtained, the low-molecular light-emitting material is preferably used as the light-emitting material, and the low-molecular light-emitting material having an aromatic ring structure is particularly preferred. Specifically, the low-molecular host material and the low-molecular dopant material are more preferably used, and tris[2-(p-tolyl)pyridine] iridium (Ir(mppy)₃) and 9,9'-(p-tert-butylphenyl)-1,3-biscarbazole are still more preferably used.

### [Binder resin]

The binder resin according to the present invention is a binder resin containing a multi-branched copolymer of a monovinyl compound composed of a styrene-based monomer as an essential component with a multifunctional vinyl compound containing two or more ethylenically unsaturated double bonds, the copolymer having a weight-average absolute molecular weight within a range of 200,000 to 800,000 determined by gel permeation chromatography using a multi-angle laser light scattering detector and a degree of branching within a range of 0.20 to 0.55 determined from an inertial radius. The multi-branched copolymer used is preferably soluble in a solvent described below.

A difference between the present invention and the prior art described above lies in the constituent component of the binder resin. The multi-branched copolymer of the monovinyl compound composed of a styrene-based monomer as an essential component with the multifunctional vinyl compound containing two or more ethylenically unsaturated double bonds, which is used in the present invention and which has a weight-average absolute molecular weight within a range of 200,000 to 800,000 determined by gel permeation chromatography using a multi-angle laser light scattering detector and a degree of branching within a range of 0.20 to 0.55 determined from an inertial radius, is clearly distinguished, in the molecular weight range and the branching degree range, from a linear polystyrene, a block copolymer of styrene with another comonomer, and a graft copolymer of a styrene-based monomer with another comonomer, which have been used for forming an organic light-emitting device.

In the present invention, a copolymer which shows a higher molecular weight and a higher degree of branching than usual and which has a weight-average absolute molecular weight within a range of 200,000 to 800,000 determined by gel permeation chromatography using a multi-angle laser light scattering detector and a degree of branching within a range of 0.20 to 0.55 determined from an inertial radius may be selected from known common copolymers of a monovinyl compound composed of a styrene-based monomer as an essential component with a multifunctional vinyl compound containing two or more ethylenically unsaturated double bonds.

The copolymer of the monovinyl compound composed of a styrene-based monomer as an essential component with the multifunctional vinyl compound containing two or more ethylenically unsaturated double bonds can be easily produced by radical copolymerization of the monovinyl compound composed of a styrene-based monomer as an essential component with the multifunctional vinyl compound containing two or more ethylenically unsaturated double bonds.

Examples of the styrene-based monomer which can be used in the present invention include compounds described below. Examples of styrene and derivatives thereof include styrene, alkylstyrenes such as methylstyrene, dimethylstyrene, trimethylstyrene, ethylstyrene, diethylstyrene, triethylstyrene, propylstyrene, butylstyrene, hexylstyrene, heptylstyrene, octylstyrene, and the like, halogenated styrenes such as fluorostyrene, chlorostyrene, bromostyrene, dibromostyrene, iodostyrene, and the like, nitrostyrene, acetylstyrene, methoxystyrene, and the like. These can be used alone or in combination of two or more.

The monovinyl compound may be composed of only the styrene-based monomer or may be a mixture of a styrene-based monomer and another monovinyl compound. The monovinyl compound other than the styrene-based monomer may be any monovinyl compound as long as it has an olefinically double bond copolymerizable with the styrene-based monomer. Examples thereof include monomers having at least one type of ethylenically unsaturated double bond, such as olefins such as ethylene, propylene, butylene, and the like, vinyl cyanides such as acrylonitrile, (meth)acrylonitrile, and the like, (meth)acrylic acid esters such as butyl (meth)acrylate, methyl (meth)acrylate, and the like, (meth)acrylic acid such as acrylic acid, methacrylic acid, and the like, α,β-ethylenically unsaturated carboxylic acids (organic acid anhydrides) such as maleic anhydride, fumaric acid, and the like, imide-based monomers such as phenylmaleimide, cyclohexylmaleimide, and the like. These other monovinyl compounds can be used alone or in combination of two or more.

The ratio of the styrene-based monomer to the other monovinyl compound is not particularly limited, and the styrene-based monomer can be adjusted to 50 to 100 mol%, and the other monovinyl compound can be adjusted to 50 to 0 mol%. However, the copolymer composed of only the styrene-based monomer without containing the other monovinyl compound, such as a monomer containing at least one type of ethylenically unsaturated double bond selected from the group consisting of olefins, (meth)acrylic acid esters, (meth)acrylic acid, and organic acid anhydrides is preferred because as described below, the binder resin containing the resultant multi-branched copolymer has more excellent light emission properties such as a current efficiency and the like.

On the other hand, examples of the multifunctional vinyl compound containing two or more ethylenically unsaturated double bonds include divinyl aromatic compounds such as divinylbenzene, aliphatic/alicyclic (meth)acrylate such as ethylene glycol di(meth)acrylate, and the like.

However, the multifunctional vinyl compound containing two or more ethylenically unsaturated double bonds used preferably has a higher molecular weight rather than the relatively low molecular weight as described above because the copolymer having a high molecular weight tends to be easily produced with little causing gelation during copolymerization with the monovinyl compound composed of a styrene-based monomer as an essential component. The multifunctional vinyl compound containing two or more ethylenically unsaturated double bonds and having a high molecular weight is also referred to as the "multi-branched macromonomer". The multifunctional vinyl compound containing two or more ethylenically unsaturated double bonds is preferably, for example, a multifunctional vinyl compound having a weight-average molecular weight of 1,000 to 15,000 and containing two or more ethylenically unsaturated double bonds.

The multifunctional vinyl compound containing two or more ethylenically unsaturated double bonds and having a high molecular weight can be produced, for example, according to a method disclosed in Japanese Unexamined Patent Application Publication No. 2003-292707, Japanese Unexamined Patent Application Publication No. 2004-123873, Japanese Unexamined Patent Application Publication No. 2005-213443, WO2009/110453, Japanese Unexamined Patent Application Publication No. 2013-100427, etc.

The multifunctional vinyl compound containing two or more ethylenically unsaturated double bonds and having a high molecular weight is, for example, that produced by any one of methods (1) to (7) described below.
(1) A multifunctional vinyl compound produced by producing a multi-branched self-condensed polycondensate as a precursor by nucleophilic substitution reaction of an AB2-type monomer having, in one molecule, an active methylene group and bromine, chlorine, a methylsulfonyloxy group, or a tosyloxy group, or the like, and introducing a polymerizable double bond into the polycondensate by nucleophilic substitution reaction of an unreacted active methylene group or methine group remaining in the polycondensate with chloromethylstyrene, bromomethylstyrene, or the like.
(2) A multifunctional vinyl compound produced by producing a multi-branched polymer having a branch structure formed by repeating a structural unit having an ester bond by reaction of a compound having one or more hydroxyl groups with a monocarboxylic acid having a saturated carbon atom as a carbon atom adjacent to the carboxyl group, the hydrogen atoms on the carbon atom which are all substituted, and two or more hydroxyl groups, and then introducing a polymerizable double bond into the multi-branched polymer by reaction with acrylic acid, methacrylic acid, isocyanate group-containing acrylic compound, 4-chloromethylstyrene, or the like.
(3) A multifunctional vinyl compound produced by producing a multi-branched polymer having a branch structure formed by repeating a structural unit having an ether bond by reaction of a compound having one or more hydroxyl groups with a cyclic ether compound having one or more hydroxyl groups, and then introducing a polymerizable double bond into the multi-branched polymer by reacting the hydroxyl groups as the terminal groups of the polymer with acrylic acid, methacrylic acid, isocyanate group-containing acrylic compound, 4-chloromethylstyrene, or the like.
(4) A multifunctional vinyl compound produced by producing a multi-branched polymer by reacting a compound having one or more hydroxyl groups with a compound having two or more hydroxyl groups and a halogen atom, -SO₂OCH₃, - OSO₂CH₃, or the like, and then introducing a polymerizable double bond into the polymer by reacting the hydroxyl groups as the terminal groups of the polymer with acrylic acid, methacrylic acid, isocyanate group-containing acrylic compound, 4-chloromethylstyrene, or the like.
(5) A multifunctional vinyl compound produced by introducing a polymerizable double bond into a PAMAM dendrimer having a repeating structure in which amide bonds are connected through a nitrogen atom, by reaction with acrylic acid, methacrylic acid, isocyanate group-containing acrylic compound, 4-chloromethylstyrene, or the like.
(6) A multifunctional vinyl compound produced by introducing a polymerizable double bond by cationic copolymerization of divinylbenzene as an essential component with styrene and, if required, another copolymerizable monovinyl compound in the presence of a co-catalyst selected from Lewis acid catalysts and ester compounds.

In order to produce a multi-branched copolymer described below so as to prevent gelation, the multifunctional vinyl compound containing two or more ethylenically unsaturated double bonds is preferably a multifunctional vinyl compound having a weight-average molecular weight of 1000 to 15,000 and two or more ethylenically unsaturated double bonds. Also, the multifunctional vinyl compound containing two or more ethylenically unsaturated double bonds is preferably a multifunctional vinyl compound having a polymer structure with a branched structure formed by repeating a structural unit having an ester bond, an ether bond, or an amide bond, and having two or more polymerizable ethylenically unsaturated double bonds at branch ends in one molecule.

In producing the multifunctional vinyl compound by the production method described above, it is possible to use the Williamson ether synthesis method described in in Tamalia, et al "Angew. Chem. Int. Ed. Engl. 29" p. 138-177 (1990), and Generation 2.0 manufactured by Dentoritech Co., Ltd. or the like as the PAMAM dendrimer.

The binder resin containing the multi-branched copolymer used in the present invention can be produced by polymerizing 0.01 to 1 parts on a mass basis of the multifunctional vinyl compound containing two or more ethylenically unsaturated double bonds per 100 parts of the monovinyl compound composed of a styrene-based monomer as an essential component.

When the monovinyl compound composed of a styrene-based monomer as an essential component is copolymerized with the multifunctional vinyl compound containing two or more ethylenically unsaturated double bonds, the resultant binder resin is composed of a mixture of polymers including not only a corresponding multi-branched copolymer but also a corresponding low-branch copolymer and a linear copolymer of the monovinyl compound composed of a styrene-based monomer as an essential component according to the polymerization conditions.

Various general-purpose methods for polymerizing a styrene-based monomer can be used for polymerization reaction. The polymerization method is not particularly limited, but bulk polymerization, suspension polymerization, or solution polymerization is preferred. Among these, continuous bulk polymerization is particularly preferred in view of production efficiency. Thermal polymerization without using a polymerization initiator can be performed, but any one of various radical polymerization initiators is preferably used. In addition, polymerization auxiliaries such as a suspension agent, an emulsifier, and the like necessary for polymerization, which are generally used for producing polystyrene, can also be used.

In addition, an organic solvent may be added to the reaction system in order to decrease the viscosity of a reaction product of polymerization reaction. Examples of the organic solvent include toluene, ethylbenzene, xylene, acetonitrile, benzene, chlorobenzene, dichlorobenzene, anisole, cyanobenzene, dimethylformamide, N,N-dimethylacetamide, methyl ethyl ketone, and the like. In particular, when it is desired to increase the content of a portion based on polymerization of the multifunctional vinyl compound containing two or more ethylenically unsaturated double bonds in the multi-branched copolymer, the organic solvent is preferably used from the viewpoint of suppressing gelation. In this case, many branch structures can be introduced by significantly increasing the amount of the multifunctional view compound added, and gelation little occurs.

Examples of the radical polymerization initiator include, but are not particularly limited to, peroxy ketals such as 1,1-bis(tert-butylperoxy)cyclohexane, 2,2-bis(tert-butylperoxy)butane, 2,2-bis(4,4-di-butylperoxy cyclohexyl)propane, and the like; hydroperoxides such as cumene hydroperoxide, tert-butyl hydroperoxide, and the like; dialkyl peroxides such as di-tert-butyl peroxide, dicumyl peroxide, di-tert-hexyl peroxide, and the like; diacyl peroxides such as benzoyl peroxide, dicinnamoyl peroxide, and the like; peroxyesters such as tert-butyl peroxybenzoate, di-tert-butyl peroxyisophthalate, tert-butyl peroxyisopropyl monocarbonate, and the like; N,N'-azobisisobutyronitrile, N,N'-azobis(cyclohexane-1-carbonitrile), N,N'-azobis(2-methylbutyronitrile), N,N'-azobis(2,4-dimethylvaleronitrile), N,N'-azobis[2-(hydroxymethyl)propionitrile], and the like. These can be used alone or in combination of two or more.

Further, a chain transfer agent may be added so as to prevent an excessive increase in the molecular weight of the resultant multi-branched copolymer. Either a monofunctional chain transfer agent having one chain transfer group or a multifunctional chain transfer agent having a plurality of chain transfer groups may be used as the chain transfer agent. Examples of the monofunctional chain transfer agent include alkyl mercaptans, thioglycolic acid esters, and the like. Examples of the multifunctional chain transfer agent include those produced by esterifying hydroxyl groups in polyhydric alcohol, such as ethylene glycol, neopentyl glycol, trimethylolpropane, pentaerythritol, dipentaerythritol, tripentaerythritol, sorbitol, and the like, with thioglycolic acid or 3-mercaptopropionic acid.

Also, long-chain alcohol, polyoxyethylene alkyl ether, polyoxyethylene lauryl ether, polyoxyoleyl ether, polyoxyethylene alkenyl ether, or the like can be used for suppressing the occurrence of gelation of the resultant resin composition.

Further, a binder resin insoluble content (solid content) is produced by bulk polymerization or by solution polymerization using a solvent different from the solvent used for preparing the ink composition and further removal of the solvent, and then a binder resin solution can be produced by adding the solvent used for preparing the ink composition.

In the present invention, as described above, the binder resin may be composed of only the multi-branched copolymer (100%) described above, but may further contain a linear copolymer of the monovinyl compound composed of a styrene-based monomer as an essential component. The linear copolymer used is also soluble in a solvent described below.

Therefore, by polymerizing 0.01 to 1 part on a mass basis of the multifunctional vinyl compound containing two or more ethylenically unsaturated double bonds per 100 parts of the monovinyl compound composed of a styrene-based monomer as an essential component, it is possible to easily produce the binder resin containing the multi-branched copolymer of the monovinyl compound composed of a styrene-based monomer as an essential component and the multifunctional vinyl compound containing two or more ethylenically unsaturated double bonds and the linear copolymer of the monovinyl compound composed of a styrene-based monomer as an essential component.

The multi-branched copolymer of the monovinyl compound composed of a styrene-based monomer as an essential component and the multifunctional vinyl compound containing two or more ethylenically unsaturated double bonds and the linear copolymer of the monovinyl compound composed of a styrene-based monomer as an essential component may be separately produced by polymerization, and the copolymers may be mixed at any desired mixing ratio to produce a mixture as the binder resin. However, it is preferred to use, as the binder resin, the copolymer produced by copolymerizing the monovinyl compound composed of a styrene-based monomer as an essential component with the multifunctional vinyl compound containing two or more ethylenically unsaturated double bonds.

Therefore, the multi-branched copolymer and the linear copolymer are uniformly dispersed and mixed, but unlike a simple mixture without entanglement between the both copolymers at the molecular level, the binder resin contains the multi-branched copolymer and the linear copolymer which are uniformly dispersed and mixed and entangled with each other at the molecular level. Therefore, the binder resin is preferred because it exhibits specifically excellent mechanical physical properties such as coating film flexibility, strength, viscoelasticity, etc., which cannot be exhibited by the simple mixture at the same monomer composition ratio.

When the ink composition for an organic light-emitting device for ink jet recording is prepared as described below, the dischargeability of ink droplets is significantly improved by the specific viscoelasticity. Also, when the low-molecular light-emitting material containing an aromatic structure is used as the light-emitting material, the coating film uniformity in the light-emitting layer is significantly improved on the basis of the structural affinity for an aromatic ring derived from the styrene-based monomer contained in the multi-branched copolymer and the three-dimensional packing property.

The molecular weight of the binder resin containing the multi-branched copolymer can be determined by gel permeation chromatography (abbreviated as "GPC-MALLS" hereinafter) using a multi-angle laser light scattering detector and referred to as the "weight-average absolute molecular weight". The weight-average absolute molecular weight of the binder resin preferred for preparing the ink composition of the present invention is within a range of 200,000 to 800,000.

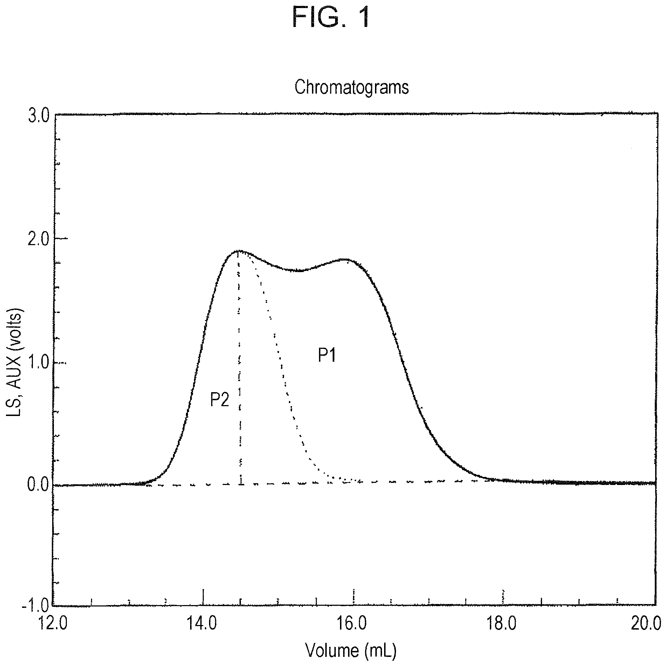

In GPC-MALLS measurement of the molecular weight of the binder resin containing the multi-branched copolymer and the linear copolymer, for example, a chromatogram as shown in Fig. 1 is produced. In Fig. 1, P1 is a peak on the low-molecular-weight side, and P2 is a peak on the high-molecular-weight side. The peak P2 is a peak mainly based on the multi-branched copolymer, while the peak P1 is a peak mainly based on the linear copolymer or the low-branch copolymer.

The content ratio between the multi-branched copolymer and other copolymers in the binder resin can be estimated from the area ratio between both peaks. In view of excellent uniformity of a coating film which forms the light-emitting layer, the ratio of multi-branched copolymer/linear copolymer is preferably peak P2 area/peak P1 area = 30/70 to 70/30 and more preferably 40/60 to 60/40.

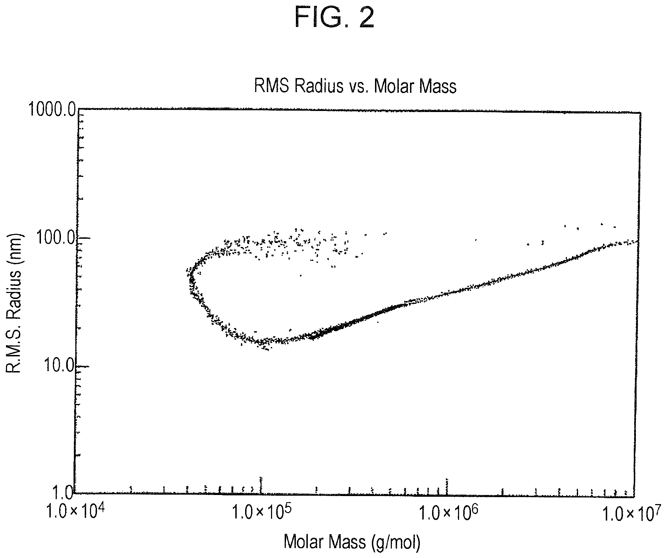

On the other hand, not only the weight-average absolute molecular weight but also the inertia radius can be determined from the GPC-MALLS chromatogram of the binder resin containing the multi-branched copolymer in the same manner. For example, as in Fig. 2, the degree of branching of the binder resin containing the multi-branched copolymer can be determined from the gradient of a straight line in a log-log graph in which the weight-average absolute molecular weight is plotted on the X-axis, and the inertial radius is plotted on the Y-axis. The gradient within the molecular weight range of 250,000 to 10,000,000 in the log-log graph is most preferably 0.20 to 0.55 from the viewpoint of exhibiting the excellent balance between film uniformity and light emission properties of the light-emitting layer. Within this range, the physical properties do not come close to those of the linear copolymer and flowability is little decreased by an increase in the molecular weight with an increase in the degree of branching.

The degree of branching of the copolymer with the monovinyl compound composed of a styrene-based monomer as the essential component increases with increases in the number of double bonds at the branch ends, which are introduced into the multifunctional vinyl compound containing two or more ethylenically unsaturated double bonds. The content of the double bond directly bonded to the aromatic ring introduced into the multifunctional vinyl compound containing two or more ethylenically unsaturated double bonds is preferably 0.1 millimoles to 5.5 millimoles and more preferably 0.5 millimoles to 3.5 millimoles per g of the multifunctional vinyl compound containing two or more ethylenically unsaturated double bonds because the multi-branched copolymer having a high molecular weight can be easily produced and an excessive increase in the molecular weight of the resultant multi-branched copolymer little occurs.

Further, the binder resin may contain not only the multi-branched copolymer but also the low-branch copolymer and the linear copolymer of the monovinyl compound composed of a styrene-based monomer as the essential component and/or various polymers different from those described above. Examples of the polymers include a polyester resin, a polyurethane resin, and the like.

The light-emitting material and the binder resin insoluble content may be contained at any desired ratio, but the binder resin insoluble content, generally on a mass basis, is preferably 10 to 1000 parts, particularly 10 to 100 parts, per 100 parts of the light-emitting material in view of obtaining excellent coating film uniformity and proper light emission properties.

### [Solvent]

The solvent is used for preparing the ink composition for an organic light-emitting device of the present invention. The solvent which can dissolve the binder resin containing the multi-branched copolymer is preferably used. The solvent is not particularly limited and a known solvent can be used. Examples thereof include aromatic solvents, alkane solvents, ether solvents, alcohol solvents, ester solvents, amide solvents, and other solvents, and the like.

Examples of the aromatic solvents include toluene, xylene, ethylbenzene, mesitylene, cyclohexylbenzene, tetralin, diphenylmethane, dimethoxybenzene, phenetol, methoxytoluene, 2,3-dimethylanisole, anisole, methylanisole, dimethylanisole, phenyl acetate, phenyl propionate, methyl benzoate, ethyl benzoate, propyl benzoate, butyl benzoate, and the like. Examples of the alkane solvents include pentane, hexane, octane, cyclohexane, and the like. Examples of the ether solvents include dioxane, ethylene glycol dimethyl ether, ethylene glycol diethyl ether, propylene glycol-1-monomethyl ether acetate, tetrahydrofuran, and the like. Examples of the alcohol solvents include methanol, ethanol, isopropyl alcohol, and the like. Examples of the ester solvents include ethyl acetate, butyl acetate, ethyl lactate, butyl lactate, and the like. Examples of the amide solvents include N,N-dimethylformamide, N,N-dimethylacetamide, and the like. Examples of other solvents include dimethyl sulfoxide, acetone, chloroform, methylene chloride, and the like.

An aromatic solvent is preferably used as the solvent in view of solubility of the multi-branched copolymer of the monovinyl compound composed of a styrene-based monomer as an essential component with the multifunctional vinyl compound containing two or more ethylenically unsaturated double bonds. From the viewpoint of being able to prevent a decrease in coating properties in association with evaporation of the solvent, it is preferred to use an aromatic solvent having a boiling point of 100°C or more, such as toluene, xylene, ethylbenzene, anisole, mesitylene, 2-methylanisole, tetralin, cyclohexylbenzene, or the like, and it is more preferred to use an aromatic solvent having a boiling point of 200°C or more, such as tetralin, cyclohexylbenzene, or the like. These solvents may be used alone or in combination of two or more.

When the low-molecular light-emitting material containing an aromatic ring structure is used as the light-emitting material, and the binder resin containing the specific multi-branched copolymer described above is used as the binder resin, like the above, the solubility in the solvent and the coating film uniformity in the light-emitting layer are significantly improved on the basis of the structural affinity for the aromatic ring contained in the chemical structure of the solvent used. Also, when the ink composition is prepared by using a combination of the solvent-soluble low-molecular light-emitting material containing an aromatic structure and the solvent-soluble binder resin, the coating film uniformity in the light-emitting layer can be more easily improved as compared with an ink composition in which one or both of them are dispersed.

Besides the light-emitting material, the binder resin, and the solvent, if required, any one of various surfactants can be added to the ink composition for an organic light-emitting device of the present invention. Examples of the surfactants which can be used include an anionic surfactant, a cationic surfactant, and a nonionic surfactant. Also, a low-molecular type or high-molecular type (polymer-type) fluorine- or silicone-based surfactant can be used.

The viscosity of the ink composition for an organic light-emitting device is preferably 1 to 50 mPa·s and more preferably 1 to 10 mPa·s. The ink composition for an organic light-emitting device preferably has a viscosity of 1 mPa·s or more because the occurrence of waviness can be preferably prevented during drying of the coating film. While the ink composition for an organic light-emitting device preferably has a viscosity of 50 mP·as or less because coating can be easily performed and productivity can be improved. In addition, when the ink composition for an organic light-emitting device of the present invention is prepared for ink jet recording, the viscosity is preferably adjusted to 1 to 20 mPa·s for securing satisfactory dischargeability. In the specification, a value measured by a rotational viscometer is used as a value of "viscosity".

### <Method for producing ink composition for organic light-emitting device>

In an embodiment of the present invention, examples of the method for producing the ink composition for an organic light-emitting device include, but are not particularly limited to, (1) a method of preparing a solution or dispersion containing the binder resin and the solvent and then adding the light-emitting material to the solution or dispersion, (2) a method of preparing a solution or dispersion containing the light-emitting material and the solvent and then adding the binder resin to the solution or dispersion, (3) a method of preparing a solution or dispersion containing the binder resin and the solvent and a solution or dispersion containing the light-emitting material and the solvent and then mixing the solutions or dispersions, and the like.

In preparing an ink for ink jet recording, coarse particles are generally moved by centrifugal separation or filter filtration in any desired step for preparing the ink in order to avoid nozzle clogging with the coarse particles or the like.

In addition, the light-emitting material, the binder resin, the solvent, etc. used as raw materials for preparing the ink are preferably high-purity products containing as little impurities and ion components as possible. This is because nozzle clogging can be prevented from being caused by the production of a deposit due to reaction on the nozzle when ink jet recording described below is continuously performed, and because an excellent organic light-emitting device is produced, in which the functions required between outer layers on both sides of the light-emitting layer as a center layer can be satisfactory exhibited and high reliability can be exhibited even in long-term continuous use.

The ink for ink jet recording prepared as described above can be used for, for example, known common ink jet recording-system printers of various on-demand types, such as a piezo type and a thermal type.

### <Organic light-emitting device>

According to an embodiment of the present invention, there is provided an organic light-emitting device including a positive electrode, a light-emitting layer, and a negative electrode. The organic light-emitting device may further include one or more other layers such as a hole injection layer, a hole transport layer, an electron transport layer, an electron injection layer, and the like. Also, a known encapsulating member may be contained. Each of the components is described in detail below.

### [Positive electrode]

The positive electrode is not particularly limited, but a metal such as gold (Au) or the like, copper iodide (CuI), indium tin oxide (ITO), tin oxide (SnO₂), zinc oxide (ZnO), or the like can be used. These materials may be used alone or in combination of two or more.

The film thickness of the positive electrode is not particularly limited, but is preferably 10 to 1000 nm and more preferably 10 to 200 nm.

The positive electrode can be formed by a method such as vapor deposition, sputtering, or the like. In this case, a pattern may be formed by a method using a photolithography method and a mask.

### [Hole injection layer]

The hole injection layer is an arbitrary component in the organic light-emitting device and has the function of taking in holes from the positive electrode. The holes taken in from the positive electrode are generally transported to the hole transport layer or the light-emitting layer.

Examples of a material which can be used for the hole injection layer include, but are not particularly limited to, a phthalocyanine buffer layer of copper phthalocyanine or the like; an oxide buffer layer of vanadium oxide or the like; an amorphous carbon buffer layer; polymer buffer layers of polyaniline(emeraldine), poly(3,4-ethylene dioxythiophene)-poly(styrenesulfonic acid) (PEDOT-PSS), and the like. These materials may be used alone or in combination of two or more.

The film thickness of the hole injection layer is not particularly limited, but is preferably 0.1 nm to 5 µm.

### [Hole transport layer]

The hole transport layer is an arbitrary component in the organic light-emitting device and has the function of efficiently transporting holes. The hole transport layer also may have the function of preventing transport of holes. The hole transport layer generally takes in holes from the positive electrode or the hole injection layer and transports the holes to the light-emitting layer.

Examples of a material which can be used for the hole transport layer include, but are not particularly limited to, low-molecular triphenylamine derivatives such as TPD (N,N'-diphenyl-N,N'-di(3-methylphenyl)-1,1'-biphenyl-4,4'diamine), α-NPD (4,4'-bis[N-(1-naphthyl)-N-phenylamino]biphenyl), m-MTDATA (4,4',4"-tris(3-methylphenylphenylamino)triphenylamine), and the like; polyvinylcarbazole; a high-molecular compound produced by polymerizing a triphenylamine derivative represented by chemical formula HT-2 below in which a polymerizable substituent is introduced; and the like. These materials may be used alone or in combination of two or more.

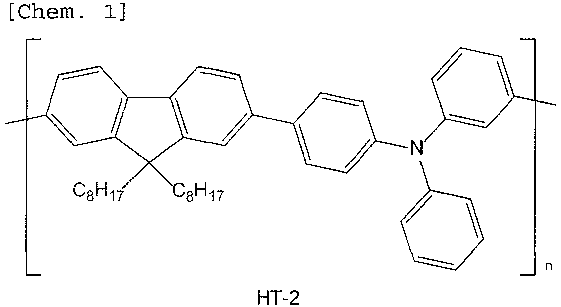

The film thickness of the hole transport layer is not particularly limited, but is preferably 1 nm to 5 µm, more preferably 5 nm to 1 µm, and still more preferably 10 to 500 nm.

The hole transport layer may be a single layer or a laminate of two or more layers.

The hole transport layer can be generally formed by a vacuum vapor deposition method, a spin coating method, a cast method, an ink jet method, a LB method, or the like.

### [Light-emitting layer]

The light-emitting layer has the function of emitting light by using the energy produced by recombination between the holes and electrons injected into the light-emitting layer.

The light-emitting layer is formed by using the ink composition for an organic light-emitting device of the present invention and thus contains the light-emitting material and binder resin described above. The mixing ratio between the light-emitting material and the binder resin insoluble content is not particularly limited, but the binder resin insoluble content, generally in terms of mass, is preferably 10 to 100 parts per 100 parts of the light-emitting material because the resultant organic light-emitting device exhibits the excellent characteristics described above.

The light-emitting layer includes a light-emitting layer formed by using the ink composition for an organic light-emitting device of the present invention and a light-emitting layer formed by using a known ink composition for an organic light-emitting layer and a light-emitting layer formed by vapor deposition or the like.

The film thickness of the light-emitting layer is not particularly limited, but is preferably 2 to 100 nm and more preferably 2 to 20 nm.

The light-emitting layer can be generally formed by applying the ink composition for an organic light-emitting device of the present invention and drying the resultant coating film.

Examples of the coating method include, but are not particularly limited to, an ink jet printing method, a letterpress reverse printing method, a gravure offset printing method, a screen printing method, a nozzle print printing method, and the like. When the thinner light-emitting layer having a narrower thickness distribution, higher uniformity, and a narrower line-and-space (L/S) is formed, the letterpress reverse printing method is more preferably used.

### [Electron transport layer]

The electron transport layer is an arbitrary component in the organic light-emitting device and has the function of efficiently transporting electrons. The electron transport layer also may have the function of preventing transport of electrons. The electron transport layer generally takes in electrons from the negative electrode or the electron injection layer and transports the electrons to the light-emitting layer.

Examples of a material which can be used for the electron transport layer include, but are not particularly limited to, metal complexes each having a quinoline skeleton or benzoquinoline skeleton, such as tris(8-quinolilate) aluminum (Alq), tris(4-methyl-8-quinolinolato) aluminum (Almq3), bis(10-hydroxybenzo[h]quinolinato) beryllium (BeBq2), bis(2-methyl-8-quinolinolate)(p-phenylphenolato) aluminum (BAlq), bis(8-quinolinolate) zinc (Znq), and the like; metal complexes each having a benzoxazoline skeleton, such as bis[2-(2'-hydroxyphenyl)benzoxazolato]zinc (Zn(BOX)2) and the like; metal complexes each having a bonzothiazoline skeleton, such as bis[2-(2'-hydroxyphenyl)benzothiazolato]zinc (Zn(BTZ)2) and the like; polyazole derivatives such as 2-(4-biphenyl)-5-(4-tert-butylphenyl)-1,3,4-oxadiazole (PBD), 3-(4-biphenyl)-4-phenyl-5-(4-tert-butylphenyl)-1,2,4-triazole (TAZ), 1,3-bis[5-(p-tert-butylphenyl)-1,3,4-oxadiazol-2-yl]benzene (OXD-7), 9-[4-(5-phenyl-1,3,4-oxadiazol-2-yl)phenyl]carbazole (CO11), 2,2',2"-(1,3,5-benzenetriyl) tris(1-phenyl-1H-benzoimidazole) (TPBI), 2-[3-(dibenzothiophen-4-yl)phenyl]-1-phenyl-1H-benzoimidazole (mDBTBIm-II), and the like; benzoimidazole derivatives represented by chemical formula ET-1 below; quinoline derivatives; perylene derivatives; pyridine derivatives; pyrimidine derivatives; quinoxaline derivatives; diphenoxyquinone derivatives; nitro-substituted fluorene derivatives; and the like.

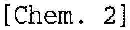

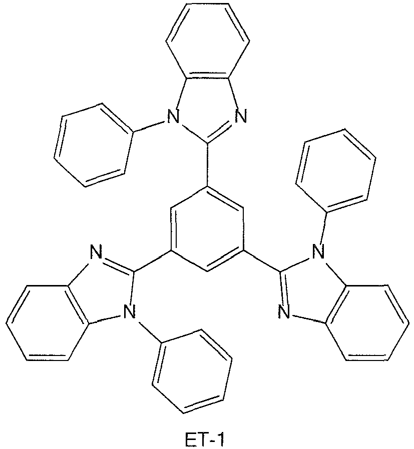

The film thickness of the electron transport layer is not particularly limited, but is preferably 5 nm to 5 µm and more preferably 5 nm to 200 nm.

The electron transport layer may include a single layer or a laminate of two or more layers.

The electron transport layer can be generally formed by a vapor deposition method, a spin coating method, a cast method, an ink jet method, a LB method, or the like.

### [Electron injection layer]

The electron injection layer is an arbitrary component in the organic light-emitting device and has the function of taking in electrons from the negative electrode. The electrons taken in from the negative electrode are generally transported to the electron transport layer or the light-emitting layer.

Examples of a material which can be used for the electron injection layer include, but are not particularly limited to, metal buffer layers of strontium, aluminum, and the like; alkali metal compound buffer layers of lithium fluoride and the like; alkaline-earth metal compound buffer layers of magnesium fluoride and the like; oxide buffer layers so aluminum oxide and the like; and the like. These materials may be used alone or in combination of two or more.

The film thickness of the electron injection layer is not particularly limited, but is preferably 0.1 nm to 5 µm.

### [Negative electrode]

Examples of the negative electrode include, but are not particularly limited to, lithium, sodium, magnesium, aluminum, a sodium-potassium alloy, a magnesium/aluminum mixture, a magnesium/indium mixture, an aluminum/aluminum oxide (Al₂O₃) mixture, a rare earth metals, and the like. These materials may be used alone or in combination of two or more.

The negative electrode is generally formed by a method of vapor deposition, sputtering, or the like.

The film thickness of the negative electrode is not particularly limited, but is preferably 10 to 1000 nm and more preferably 10 to 200 nm.

The organic light-emitting device including the light-emitting layer formed by using the ink composition for an organic light-emitting device of the present invention is preferably capable of preventing waviness of the light-emitting layer formed. Therefore, the resultant organic light-emitting device has the high performance of preventing brightness unevenness or the like.

### EXAMPLES

The present invention is specifically described below by giving examples, but the present invention is not limited to these examples. In the examples, the term "parts" used represents "parts by mass" unless otherwise specified.

### <PREPARATION EXAMPLE 1>

Preparation example of high-molecular-weight multifunctional vinyl compound containing two or more ethylenically unsaturated double bonds

In a 2-liter flask provided with a stirrer, a thermometer, a dropping funnel, and a condenser, 50.5 g of ethoxylated pentaerythritol (5 mole-ethylene oxide-added pentaerythritol) and 1 g of a BF3 diethyl ether solution (50%) were added and heated to 110°C. Then, 450 g of 3-ethyl-3-(hydroxymethyl)oxetane was slowly added to the resultant mixture over 25 minutes while heat generation by the reaction was controlled. When the generation of heat stopped, the reaction mixture was further stirred at 120°C for 3 hours and then cooled to room temperature. The resultant multi-branched polyether polyol had a weight-average molecular weight of 3,000 and a hydroxyl value of 530 (branching agent 1).

In a reactor provided with a stirrer, a thermometer, a Dean-Stark decanter with a condenser, and a gas inlet tube, 50 g of the branching agent 1 obtained as described above, 13.8 of methacrylic acid, 150 g of toluene, 0.06 g of hydroquinone, and 1 g of para-toluenesulfonic acid were added, and stirred and heated under normal pressure while 7% oxygen-containing nitrogen (v/v) was blown into the mixed solution at a rate of 3 milliliter/min. The heating amount was adjusted so that the amount of distillate to the decanter was 30 g per hour, and heating was continued until the amount of water removed reached 2.9 g. After the completion of reaction, the reaction mixture was cooled once, and 36 g of acetic anhydride and 5.7 g of sulfamic acid were added, followed by stirring at 60°C for 10 hours. Then, in order to remove the remaining acetic acid and hydroquinone, the mixture was washed four times with 50 g of a 5% aqueous sodium hydroxide solution, one time with 50 g of a 1% aqueous sulfuric acid solution, and two times with 50 g of water. Then, 0.02 g of methoquinone was added to the resultant organic layer, and the solvent was distilled off under reduced pressure while 7% oxygen-containing nitrogen (v/v) was introduced, thereby producing 60 g of multi-branched polyether having an isopropenyl group and an acetyl group. The multi-branched polyether had a weight-average molecular weight of 3,900, and the rates of the isopropenyl group and acetyl group introduced into the multi-branched polyether polyol were 30 mol% and 62 mol%, respectively (high-molecular-weight multifunctional vinyl compound 1 containing two or more ethylenically unsaturated double bonds).

### <PREPARATION EXAMPLE 2>

Preparation example of high-molecular-weight multifunctional vinyl compound containing two or more ethylenically unsaturated double bonds

In a reactor provided with a 7% oxygen inlet tube, a thermometer, a Dean-Stark decanter with a condenser, and a stirrer, 10 g of multi-branched polyester polyol "Boltorn H20", 1.25 g of dibutyltin oxide, 100 g of methyl methacrylate having an isopropenyl group as a functional group, and 0.05 g of hydroquinone were added and heated under stirring while 7% oxygen was blown into the mixed solution at a ratio of 3 ml/min. The heating amount was adjusted so that the amount of distillate to the decanter was 15 to 20 g per hour, and the distillate in the decanter was taken out every hour. Then, reaction was performed for 6 hours while methyl methacrylate in an amount corresponding to the distillate taken out was added.

After the completion of reaction, methyl methacrylate was distilled off under reduced pressure and, in order to cap the remaining hydroxyl group, 10 g of acetic anhydride and 2 g of sulfamic acid were added, followed by stirring at room temperature for 10 hours. The sulfamic acid was removed by filtration, and acetic anhydride and acetic acid were distilled off under reduced pressure. Then, the residue was dissolved in 70 g of ethyl acetate, and the resultant solution was washed four times with a 5% aqueous sodium hydroxide solution in order to remove the hydroquinone. Further, the mixture was washed two times with 20 g of a 7% aqueous sulfuric acid solution and two times with 20 g of water. Then, 0.0045 g of methoquinone was added to the resultant organic layer, and the solvent was distilled off under reduced pressure while 7% oxygen was introduced, thereby producing 12 g of multi-branched polyester having an isopropenyl group and an acetyl group. The resultant multi-branched polyester had a weight-average molecular weight of 2860 and a number-average molecular weight of 3770, and the rates of the isopropenyl group and acetyl group introduced into the multi-branched polyester polyol were 55% and 40%, respectively (high-molecular-weight multifunctional vinyl compound 2 containing two or more ethylenically unsaturated double bonds).

### <SYNTHESIS EXAMPLE 1>

A mixed solution containing 90 parts of a styrene monomer, 700 ppm of the high-molecular-weight multifunctional vinyl compound 1 prepared in Preparation Example 1 relative to the styrene monomer, and 10 parts of toluene was prepared. Further, 200 ppm of tert-butyl peroxybenzoate as an organic peroxide relative to the styrene monomer was added to the mixed solution. Then, a binder resin 1 containing a multi-branched copolymer was produced by performing solution polymerization while stepwisely increasing the temperature from 110°C to 160°C until the unreacted styrene monomer was substantially not detected.

### <SYNTHESIS EXAMPLE 2>

A binder resin 2 containing a multi-branched copolymer was produced by the same method as in Synthesis Example 1 except that the high-molecular-weight multifunctional vinyl compound 1 prepared in Preparation Example 1 was changed to the same amount (500 ppm) of the high-molecular-weight multifunctional vinyl compound 2 prepared in Preparation Example 2 relative to the styrene monomer.

### <SYNTHESIS EXAMPLE 3>

A binder resin 3 containing a multi-branched copolymer was produced by the same method as in Synthesis Example 1 except that the mixed solution was changed to a mixed solution containing 85 parts of styrene monomer, 5 parts of butyl acrylate, the high-molecular-weight multifunctional vinyl compound 1 prepared in Preparation Example 1 at a monomer ratio of 300 ppm (relative to the total of the styrene monomer and butyl acrylate), and 10 parts of toluene.

Each of the binder resins 1 to 3 of Synthesis Examples 1 to 3 contained a monovinyl compound linear copolymer composed of the styrene-based monomer as an essential component.

### <COMPARATIVE SYNTHESIS EXAMPLE>

A binder resin 4 containing a linear copolymer was produced by the same method as in Synthesis Example 1 except that a mixed solution contained 90 parts of styrene monomer and 10 parts of toluene, and peroxide was not added to the mixed solution.

### (GPC-MALLS measurement)

The insoluble content of each of the binder resins of the synthesis examples and the comparative synthesis example was determined by GPV-MALS measurement using Shodex HPLC, Wyatt Technology DAWN EOS, Shodex RI-101 as a detector, Shodex KF-806L × 2 as a column, and THF as a solvent under the condition including a flow rate of 1.0 ml/min. Also, the weight-average absolute molecular weight of each of the binder resins was determined by analysis of GPC-MALLS measurement using analysis software ASTRA of Wyatt Technology Corporation. In addition, the degree of branching was determined from the gradient (gradient of an approximate straight line automatically calculated by the software based on the measurement values only in a straight line portion obtained within a molecular weight region) within a molecular weight region of 250,000 to 10,000,000 in a log-log graph in which the molecular weight of the binder resin determined by GPC-MALLS was plotted on the abscissa (X-axis), and the inertial radius was plotted on the ordinate (Y-axis).

Table 1 below summarizes the characteristics of each of the copolymers of Synthesis Examples 1 to 3 and Comparative Synthesis Example. It was confirmed by visual observation that the light-emitting material and the binder resin are uniformly dissolved in the solvent in any one of the ink compositions.

**[Table 1]**

| Binder resin | Branched /linear | Branching agent | Weight-average absolute molecular weight | Degree of branching | Comonomer |
|---|---|---|---|---|---|
| Synthesis Example 1 | Branched | Branching agent 1 | 530000 | 0.28 | Not contained |
| Synthesis Example 2 | Branched | Branching agent 2 | 480000 | 0.35 | Not contained |
| Synthesis Example 3 | Branched | Branching agent 1 | 410000 | 0.45 | Butyl acrylate |
| Comparative Synthesis Example | Linear | No | 200000 | 0.61 | Not contained |

### <Production of ink composition for organic light-emitting device>

### [EXAMPLE 1]

First, 0.01 g tris[2-(p-tolyl)pyridine]iridium (Ir(mppy)3) (manufactured by Lumtec Corporation) and 0.09 g of 9,9'-(p-tert-butylphenyl)-1,3-biscarbazole H-1 (manufactured by DIC Corporation) were mixed with 9 g of tetraline and heated and dissolved. The resultant solution was cooled to room temperature, and 0.03 g of the insoluble content of the binder resin 1 prepared in Synthesis Example 1 was added to the solution. Next, tetraline was further added so that the total amount was 10 g and sufficiently stirred. Finally, foreign substances were removed by using Myshori Disk (manufactured by Tosoh Corporation) serving as a 0.45 µm filter to produce an IJ ink composition 1 for an organic light-emitting device.

### [EXAMPLE 2]

An IJ ink composition 2 for an organic light-emitting device was produced by the same method as in Example 1 except that the insoluble content of the binder resin 1 prepared in Synthesis Example 1 was changed to the same amount of the insoluble content of the binder resin 2 prepared in Synthesis Example 2.

### [EXAMPLE 3]

An IJ ink composition 3 for an organic light-emitting device was produced by the same method as in Example 1 except that the insoluble content of the binder resin 1 prepared in Synthesis Example 1 was changed to the same amount of the insoluble content of the binder resin 3 prepared in Synthesis Example 3.

### [COMPARATIVE EXAMPLE 1]

An IJ ink composition 4 for an organic light-emitting device was produced by the same method as in Example 1 except that the insoluble content of the binder resin 1 prepared in Synthesis Example 1 was changed to the same amount of the insoluble content of the binder resin prepared in Comparative Synthesis Example.

### <Evaluation>

Each of the IJ ink compositions for an organic light-emitting device produced in Examples 1 to 3 and Comparative Example 1 was evaluated for various items.

### [Evaluation of dischargeability in ink jet printer]

Each of the IJ ink compositions for an organic light-emitting device prepared as described above was discharged on a glass substrate used as a printing substrate by using an ink jet printer (printer head: Nova PH 256/80 AAA Print head) having a piezo-type nozzle provided in the head, and whether or not stable discharge could be achieved was confirmed according to evaluation criteria below.

A: Single drops without satellites
B: Single drops with satellites
C: Double drops without satellites
D: Double drops with satellites

### [Film quality (occurrence of waviness as evaluation measure of uniformity)]

First, 0.1 µL of the IJ ink composition for an organic light-emitting device was dropped on an indium tin oxide (ITO) substrate and dried at 25°C under a reduced pressure of 1 Torr. A difference (recess-projection difference) between a projection and a recess of the resultant organic thin film was measured by using a light-interference surface shape measuring device (manufactured by Ryoka Systems Inc.) and evaluated according to criteria below. The projection represents a highest portion from a horizontal surface as a reference of the surface of the organic thin film, and the recess represents a lowest portion from a horizontal surface as a reference of the surface of the organic thin film.

A: Recess-projection difference of over 10 nm and 50 nm or less
B: Recess-projection difference of over 50 nm and 100 nm or less
C: Recess-projection difference of over 100 nm and 150 nm or less
D: Recess-projection difference of over 150 nm

The obtained results are shown in Table 2 below.

An organic light-emitting device was produced as described below by using each of the ink compositions of Examples 1 to 3 and Comparative Example 1, and the current efficiency of the resultant organic light-emitting device was measured as a light emission property.

That is, a washed ITO substrate was irradiated with UV/O3, and poly(3,4-ethyelene dioxythiophene)-poly(ethylenesulfonic acid) (PEDOT-PSS) was deposited to form a film of 45 nm by spin coating and heated at 180°C in air for 15 minutes, forming a hole injection layer. Next, a 0.3 weight % xylene solution of HT-2 represented by a formula below was deposited to form a film of 10 nm by spin coating on the hole injection layer and dried at 200°C for 30 minutes in a nitrogen atmosphere, thereby forming a hole transport layer. Next, a film of 30 nm was formed on the hole transport layer by spin coating using the IJ ink composition for an organic light-emitting device of each of Examples 1 to 3 and Comparative Example 1 and dried at 110°C for 15 minutes in a nitrogen atmosphere, thereby forming a light-emitting layer. Then, ET-1 of 45 nm serving as an electron transport layer, lithium fluoride of 0.5 nm serving as an electron injection layer, and aluminum of 100 nm serving as a negative electrode were deposited in order under a vacuum condition of 5 × 10⁻³ Pa. Finally, the substrate was transferred to a glove box and sealed with a glass substrate to produce an organic light-emitting device.

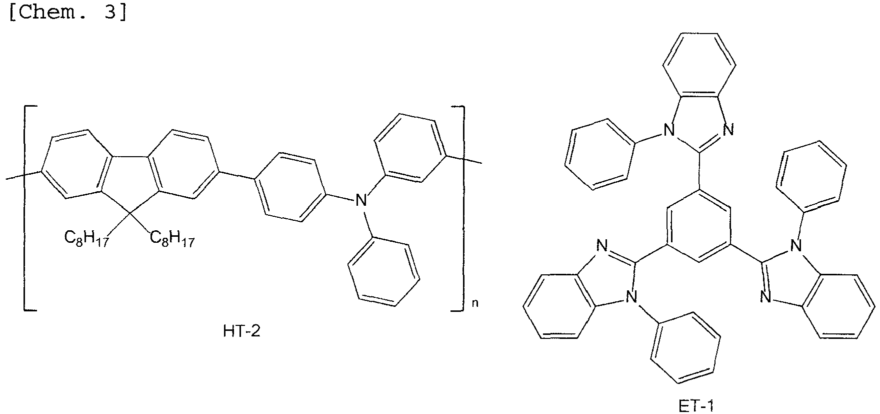

### [Luminous efficiency]

The organic light-emitting device was connected to an external power supply, and a current of 10 mA was passed to optically measure light emission from the organic light-emitting device by using BM-9 (manufactured by Topcon Corporation). In this case, the luminous efficiency at 10 mA/cm² was calculated from the current value and evaluated according to the following criteria.

A: Luminous efficiency of 25 cd/A or more and less than 30 cd/A
B: Luminous efficiency of 20 cd/A or more and less than 25 cd/A
C: Luminous efficiency of less than 20 cd/A

The obtained results are shown in Table 2 below.

**[Table 2]**

| Binder resin | IJ dischargeability | Film quality (uniformity) | Current efficiency |
|---|---|---|---|
| Example 1 | A | A | A |
| Example 2 | A | A | A |
| Example 3 | A | A | B |
| Comparative Synthesis Example | D | B | B |

Comparison between Example 1 and Comparative Example 1 of Table 2 indicates that the ink composition containing the binder resin containing the multi-branched copolymer which had both a specified molecular weight and a specified branching degree has both more excellent film quality (uniformity) and more excellent light emission property (current efficiency) and also has appropriate viscosity, and thus is also excellent in dischargeability when applied to an ink jet printer.

Also, comparison between Example 1 and Example 2 indicates that the ink composition containing the binder resin containing the multi-branched copolymer which had both a specified molecular weight and a specified branching degree has both more excellent film quality (uniformity) and more excellent light emission property (current efficiency) regardless of the type of the multifunctional vinyl compound containing two or more ethylenically unsaturated double bonds used for forming the multi-branched copolymer and having a weight-average molecular weight of 1,000 to 15,000.

### Industrial Applicability

An ink composition for an organic light-emitting device according to the present invention uses a binder resin containing a multi-branched copolymer containing a styrene-based monomer polymerization unit and having a specified molecular weight and a specified branching degree, and thus it is possible to produce a light-emitting layer having more excellent film quality, which cannot be obtained by using a binder resin containing a low-branch copolymer or a linear copolymer.

The resultant organic light-emitting device can be made an organic light-emitting device having both more excellent film quality and excellent light emission properties.

Therefore, the organic light-emitting device is useful for various light-emitting devices such as an illumination, a display, etc.

## Claims

1. An ink composition for an organic light-emitting device, the composition comprising a light-emitting material, a binder resin, and a solvent, the binder resin containing a multi-branched copolymer of a monovinyl compound composed of a styrene-based monomer as an essential component with a multifunctional vinyl compound containing two or more ethylenically unsaturated double bonds, and the copolymer having a weight-average absolute molecular weight within a range of 200,000 to 800,000 determined by gel permeation chromatography using a multi-angle laser light scattering detector and a degree of branching within a range of 0.20 to 0.55 determined from an inertial radius.

2. The ink composition for an organic light-emitting device according to Claim 1, wherein the multifunctional vinyl compound containing two or more ethylenically unsaturated double bonds is a multifunctional vinyl compound containing two or more ethylenically unsaturated double bonds and having a weight-average absolute molecular weight of 1,000 to 15,000.

3. The ink composition for an organic light-emitting device according to Claim 1, wherein the binder resin further contains a linear copolymer of the monovinyl compound composed of a styrene-based monomer as an essential component.

4. The ink composition for an organic light-emitting device according to Claim 1, wherein the binder resin is a binder resin produced by polymerizing 0.01 to 1 part of the multifunctional vinyl compound containing two or more ethylenically unsaturated double bonds per 100 parts of the monovinyl compound composed of a styrene-based monomer as an essential component, the binder resin containing the multi-branched copolymer of the monovinyl compound composed of a styrene-based monomer as an essential component and the multifunctional vinyl compound containing two or more ethylenically unsaturated double bonds and a linear copolymer of the monovinyl compound composed of a styrene-based monomer as an essential component.

5. The ink composition for an organic light-emitting device according to Claim 1, wherein the light-emitting material is a low-molecular light-emitting material having an aromatic ring structure.

6. An organic light-emitting device comprising a positive electrode, a light-emitting layer, and a negative electrode, the light-emitting layer containing a light-emitting material and a binder resin containing a multi-branched copolymer of a monovinyl compound composed of a styrene-based monomer as an essential component with a multifunctional vinyl compound containing two or more ethylenically unsaturated double bonds, and the copolymer having a weight-average absolute molecular weight within a range of 200,000 to 800,000 determined by gel permeation chromatography using a multi-angle laser light scattering detector and a degree of branching within a range of 0.20 to 0.55 determined from an inertial radius.

7. The organic light-emitting device according to Claim 6, wherein the binder resin insoluble content is contained at 10 to 1000 parts per 100 parts of the light-emitting material.
